# EUROPEAN PATENT SPECIFICATION

(11) **EP 3 435 409 B1**
(45) Date of publication and mention of the grant of the patent: **26.08.2026**
(21) Application number: 18177257.5
(22) Date of filing: 12.06.2018
(51) Int. Cl.: H10P 74/00, H10P 74/20, G01N 27/04

(54) **METHOD FOR MEASURING RESISTIVITY OF SILICON WAFERS**
VERFAHREN ZUR MESSUNG DES WIDERSTANDS VON SILIZIUM-WAFERN
PROCÉDÉ DE MESURE DE LA RÉSISTIVITÉ DE TRANCHES DE SILICIUM

(30) Priority: 26.07.2017 JP 2017144060
(43) Date of publication of application: 30.01.2019
(73) Proprietor: GlobalWafers Japan Co., Ltd., Niigata 957-0197 (JP)
(72) Inventor: Saito, Hiroyuki, Niigata, 957-0197 (JP); Kimura, Tamami, Niigata, 957-0197 (JP); Matsumura, Hisashi, Niigata, 957-0197 (JP)
(74) Representative: Hoffmann Eitle

(56) References cited:
- JP-A- H0 982 768
- JP-A- H04 259 214
- US-A1- 2014 033 797
- W. WIJARANAKULA: "Formation kinetics of oxygen thermal donors in silicon", APPLIED PHYSICS LETTERS, vol. 59, no. 13, 23 September 1991 (1991-09-23), pages 1608, XP055114038, ISSN: 0003-6951, DOI: 10.1063/1.106245
- JORDI VEIRMAN ET AL: "A Fast and Easily Implemented Method for Interstitial Oxygen Concentration Mapping Through the Activation of Thermal Donors in Silicon", ENERGY PROCEDIA, vol. 8, 20 April 2011 (2011-04-20), pages 41 - 46, XP028263041, ISSN: 1876-6102, [retrieved on 20110812], DOI: 10.1016/J.EGYPRO.2011.06.099
- KAZUMI WADA: "unified model for formation kinetics of oxygen thermal donors in silicon", PHYSICAL REVIEW, B. CONDENSED MATTER, AMERICAN INSTITUTE OF PHYSICS. NEW YORK, US, vol. 30, no. 10, 15 November 1984 (1984-11-15), pages 5884 - 5895, XP002696153, ISSN: 0163-1829, DOI: 10.1103/PHYSREVB.30.5884
- NIEWELT T ET AL: "Interstitial oxygen imaging from thermal donor growth-A fast photoluminescence based me", SOLAR ENERGY MATERIALS AND SOLAR CELLS, ELSEVIER SCIENCE PUBLISHERS, AMSTERDAM, NL, vol. 131, 27 May 2014 (2014-05-27), pages 117 - 123, XP029075014, ISSN: 0927-0248, DOI: 10.1016/J.SOLMAT.2014.05.011
- BROISCH JULIANE ET AL: "A New Method for the Determination of the Dopant-Related Base Resistivity Despite the Presence of Thermal Donors", IEEE JOURNAL OF PHOTOVOLTAICS, I E E E, US, vol. 5, no. 1, 1 January 2015 (2015-01-01), pages 269 - 275, XP011568518, ISSN: 2156-3381, [retrieved on 20141218], DOI: 10.1109/JPHOTOV.2014.2360339

## Description

### Technical Field

This invention relates to methods for measuring resistivity of Si wafers, specifically relates to a method for measuring resistivity of silicon wafers that enables to accurately measure the resistivity of Si wafers having high resistivity and a large diameter.

### Background Art

As for resistivity of Si wafers, the resistivity solely due to the remained dopant is obtained, after thermal donors that are generated through a thermal history at 450°C during crystal growth have been annihilated by a heat treatment at 650°C or more (Hereinafter as a donor killer heat treatment). As is commonly known, the resistivity, however, of wafers having a high resistivity of 2 Ω-m or more largely varies due to thermal donors generated in the thermal history passing through 450 °C when the temperature of the furnace is lowered from a donor killer treatment temperature to room temperature.

A patent literature JP No. 2003-240689 A (PL1), for example, proposes a method where wafers are thermally processed to annihilate thermal donors at a temperature of 650 °C or higher with a single-wafer type rapid thermal annealing (RTA) furnace and quenched to 300 °C. The above proposed method, however, has a disadvantage of lowering workability because of the single-wafer type processing. In a donor killer heat treatment process that is conventionally performed at a temperature of 650 °C or higher, in order to prevent lowering work efficiency, small diameter wafers such as 6 inches or less are heat-treated in a horizontal furnace and cooled in a cooling apparatus after wafer extraction, whereby generation of thermal donors during cooling process is prevented.

Large diameter wafers, such as 8 inches or larger, wafers may have a risk of breakage due to thermal stress during heat treatment or cooling because of the large size when processed in a horizontal furnace. For this reason, a plurality of large diameter wafers is commonly heat-treated in a vertical type furnace. The wafers cannot be cooled rapidly because the vertical type furnace for donor killer processing requires elevation/lowering by a boat elevator when the wafers are extracted. This causes regeneration of thermal donors due to a thermal history at 450 °C at extraction from the furnace.

For this problem, Japanese Patent No. 4970724 (PL2) proposes a technique to prevent the generation of thermal donors using a heavily carbon-doped melt at crystal growth.

Silicon crystals, however, being doped with carbon may possibly be shipped if a method with doped carbon as disclosed in PL2 is employed to prevent the generation of thermal donors; when a heat treatment is performed at customers' site, the carbon in Si crystal may become an oxygen precipitation nucleus and cause to shorten the lifetime of devices made therefrom.

Further, JP H09 82768 A discloses a method for evaluating wafer structure relating to a distribution of oxygen concentration, such as thickness measurement of an epitaxial layer in an epitaxial wafer, by measuring variation of resistivity of wafers due to thermal donors generated from interstitial oxygen when Si wafers are annealed at a low temperature, at about 450°C. Also, JP H04 259214 A discloses that resistivity is measured after thermal donors are generated in a wafer by heat treatment. W. WIJARANAKULA in "Formation kinetics of oxygen thermal donors in silicon" discloses relation between oxygen concentration and thermal donor concentration. Also, JORDI VEIRMAN ET AL in "A Fast and Easily Implemented Method for Interstitial Oxygen Concentration Mapping Through the Activation of Thermal Donors in Silicon" disclose that resistivity prior to and after annealing at 450°C are connected to thermal donor concentration or oxygen concentration.

### Summary of Invention

The present invention is made under such a circumstance; it is an object to provide a method for measuring resistivity of Si wafers capable of measuring the resistivity solely due to a dopant accurately without lowering working efficiency, where, even for large wafers, wafers can be processed to control generation of thermal donors without breakage.

The method for measuring resistivity of a Si wafer according to the present invention is set out in appended claim 1 and its dependent claims 2 and 3.

According to the method above for measuring resistivity, when the killer treatment is carried out collectively in a vertical-type heat treatment furnace (hereinafter referred to as a vertical furnace), the resistivity solely due to the dopant can be obtained based on the relational expression obtained beforehand, by eliminating an influence due to the thermal donors that are regenerated by experiencing the thermal history of 450 °C during extraction from the furnace.

Thus even for large diameter Si wafers, the resistivity solely due to the dopant is accurately evaluated after the wafers have been heat-treated in a vertical furnace which ensures high productivity, that is high working efficiency.

### Brief Description of Drawings

FIG. 1 is a flowchart of steps of a preparation process in a method for measuring resistivity of Si wafers, according to the present invention;
FIG. 2 is a schematic view of a vertical furnace to be used in the method for measuring resistivity of Si wafers, according to the present invention;
FIG. 3 is a flowchart of steps of an operation procedure in the method for measuring resistivity of Si wafers, according to the present invention;
FIG. 4 is a graph showing a result of an embodiment of the method for measuring resistivity of Si wafers, according to the present invention;
FIG. 5 is a graph showing a result of another embodiment of the method for measuring resistivity of Si wafers, according to the present invention;
FIG. 6 is a graph showing a relational expression (a general formula) between a concentration of regenerated thermal donors and each oxygen concentration contained in a Si wafer in the method for measuring resistivity of Si wafers according to the present invention; and
FIG. 7 is a table showing results of embodiments of the method for measuring resistivity of Si wafers according to the present invention.

### Description of the Preferred Embodiments

A method for measuring resistivity of Si wafers according to the present invention will be explained with reference to the drawings.

For the method according to the present invention, a vertical furnace is employed that is not a single-wafer type apparatus but can accommodate a plurality of Si wafers and perform thermal processing collectively. The method further performs a donor killer treatment where wafers are heated to a predetermined temperature to annihilate thermal donors and obtain the resistivity solely due to dopants in consideration of regenerated thermal donors.

In the present invention, preparatory processes before operation steps are carried out beforehand in order to obtain a relational expression to give a concentration of regenerated thermal donors of each of the wafers.

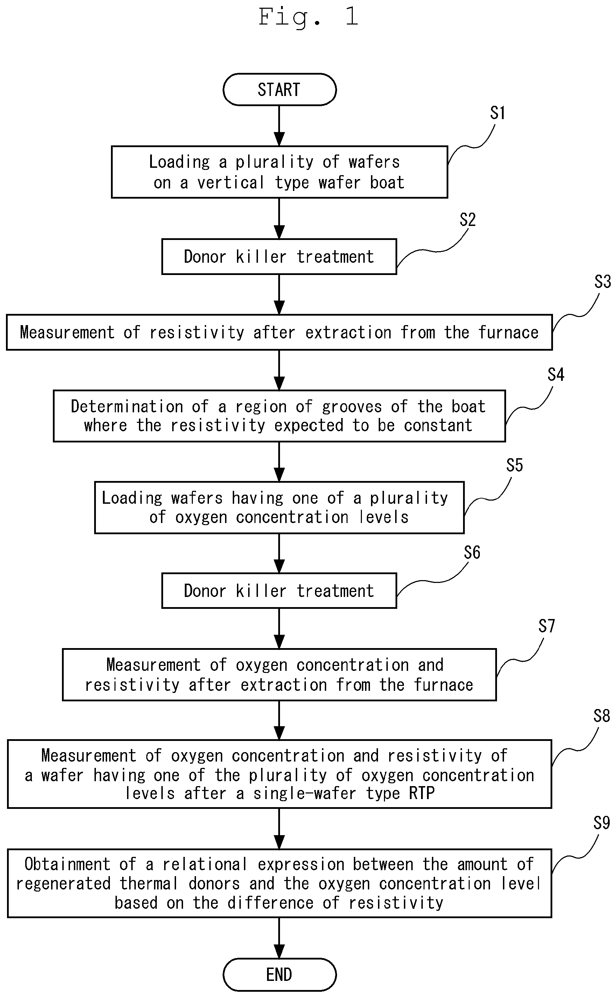

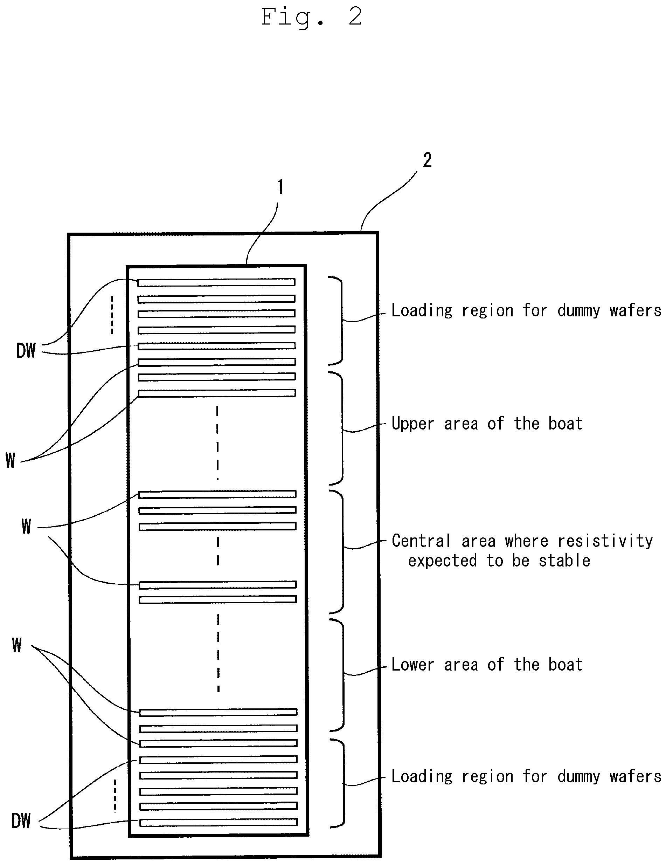

FIG. 1 is a flowchart of steps of a preparation process in a method for measuring resistivity of Si wafers, according to the present invention, and FIG. 2 is a schematic view of a vertical furnace to be used in the method for measuring resistivity of Si wafers, according to the present invention.

Firstly, twenty (20) Si wafers (with a diameter of 200 mm, for example) are mounted with a substantially equal spacing on a vertical boat 1 shown in FIG. 2 that has a hundred and twenty (120) grooves for mounting, for example (Step S1 in FIG. 1). Each wafer W to be used contain the same dopant concentration and oxygen concentration. In the vertical boat, five or more dummy wafers DW are mounted adjacent to the upper and lower side of Si product wafers.

Then, as shown in FIG. 1, the vertical boat 1 is accommodated into the vertical heat treatment furnace 2 to perform the donor killer process at 650 °C for 30 minutes in a N₂ atmosphere (Step S2 in FIG. 1).

Subsequently, the resistivity of each wafer W is measured after extracting the wafers W from the furnace at a speed of 100 mm/min that is a moving speed of the boat elevator. Measurement of the resistivity is carried out using a four-probe method that employs four needle electrodes (Step S3 in FIG.1). A region in the vertical boat 1 where the measured resistivity is found to be substantially constant is identified in a vertical position of the boat 1 (Step S4 in FIG.1). The identified region is called "a region of stable-resistivity grooves" in the present embodiment.

Next, a plurality of Si wafers W having different levels of oxygen concentration is mounted on the region of resistivity-stable grooves of the vertical boat 1 (Step S5 in FIG. 1), and the donor killer process is performed at a temperature of 650 °C for 30 min. in an N₂ atmosphere in the vertical heat treatment furnace 2 (Step S6 in FIG. 1). After extraction from the furnace at a speed of 100 mm/min, the resistivity of a first resistivity group and oxygen concentration are measured (Step S7 in FIG. 1). The measurement of the oxygen concentration is performed using an infrared absorption method, more specifically, a Fourier transform infrared spectroscopy (FT-IR). Accordingly the resistivity of the first resistivity group is the one subjected to influences of dopants and thermal donors.

A plurality of Si wafer prepared under the same condition as for steps S5 and S6 is then thermally processed in a single-wafer type rapid thermal processing (RTP) furnace at a temperature of 650 °C or higher for 30 min. in an N₂ atmosphere, and then cooled down to 300 °C at a rate of 50 °C/s or faster. In the wafers thus processed, a donor killer process, thermal donors are prevented from being regenerated and the resistivity is free from influences of the donors. The resistivity of a second resistivity group and oxygen concentration of the wafers are measured (Step S8 in FIG. 1); the resistivity is solely affected by dopants and free from influences of the thermal donors.

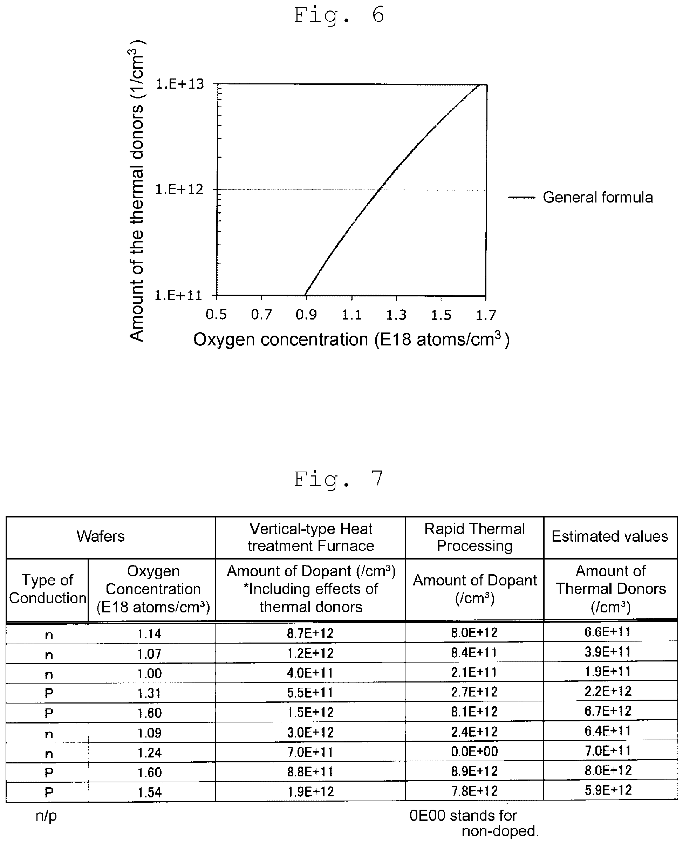

The expression (1), which shows a relationship between the concentrations of regenerated thermal donors against the respective oxygen concentration, is obtained on the basis of the difference of the resistivity measured in the step S7 and measured in the step S8. Specifically, the concentration of thermal donors is obtained for the respective wafers W having different oxygen concentration levels from the difference of resistivity values measured in the step S7 and in the step S8, and the obtained concentrations are plotted to graph. That is, as shown in FIG. 6, for example, an approximation curve (a general expression) is obtained wherein let the vertical axis be an logarithm of the concentration of thermal donors and the horizontal axis be the oxygen concentration, and then the obtained expression corresponds to the relational expression (1).

The relational expression can be given by an expression (1) below, by letting TD denote the concentration of the thermal donors, Oi the oxygen concentration, A a coefficient, and B an exponent: $TD = A {\left[Oi\right]}^{B} .$

The resistivity and the concentration of thermal donors can be estimated by using Irvin's curve, which is a general relationship between resistivity and carrier concentration including dopant concentration and thermal donor concentration, when the influence of a dopant atom and a thermal donor to the resistivity is considered to be equivalent. Namely, this estimation can be carried out using the following expressions (2) and (3) that are standardized by SEMI Standards (SEMI-MF723); the expression (2) shows a relationship of acceptor concentration and resistivity and expression (3) shows a relationship of donor concentration and resistivity, where N_{A} denotes Boron concentration and ρ denotes resistivity in expression (2), and N_{D} denotes phosphor concentration and ρ denotes resistivity in expression (3). ${N}_{A} = 1.330 \times {10}^{16} / ρ + 1.082 \times {10}^{17} / ρ \left[1+{\left(54.56\right)}^{1.105}\right] ,$ ${N}_{D} = 6.242 \times {10}^{18} \times {10}^{z} / ρ ,$ where z = (A₀+A₁X+A₂X²+A₃X³)/(1+B₁X+B₂X²+B₃X³),
X = log₁₀ ρ, and
A₀ = -3.1083, A₁ = -3.2626, A₂ = -1.2196, A₃ = -0.13923,
B₁ = 1.0265, B₂ = 0.38755, B₃ = 0.041833.

After the expression (1) for obtaining the concentration of regenerated thermal donors is thus obtained, an operation procedure for determining resistivity solely due to dopants can be carried out.

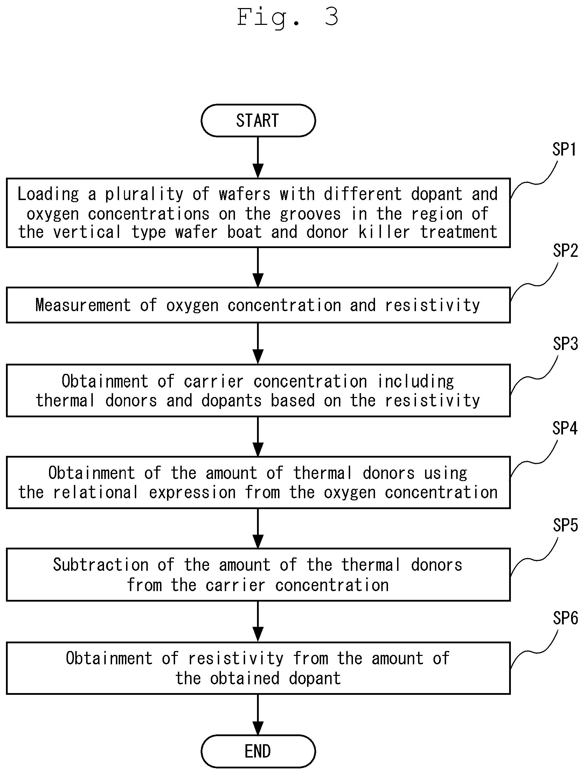

FIG. 3 is a flowchart of steps of an operation procedure in the method for measuring resistivity of Si wafers, according to the present invention.

In the operation procedure, product wafers W are subjected to the donor killer process (Step SP1 in FIG. 3); the wafers having different dopant and oxygen concentration are mounted on the region of resistivity-stable grooves of the vertical boat1 and heated at 650 °C or higher for 30 min in an N₂ atmosphere in a vertical furnace.

The wafers W are extracted from the furnace at a speed of 100 mm/min. Resistivity subjected to influences of thermal donors and concentration of oxygen of the wafers W are measured (Step SP2 in FIG.3), where thermal donors are regenerated due to a thermal history of 450 °C. Carrier concentration of the each wafer W is obtained from the measured resistivity based on Irvin's curve (Step SP3 in FIG. 3); the carrier concentration value includes that of thermal donors and the dopant.

The concentration of the thermal donors of each wafer W is obtained from the measured oxygen concentration in the step SP2 using the relational expression (1) (Step SP4 in FIG. 3).

Then carrier concentration solely due to the dopants is obtained by subtracting that of the thermal donors obtained in the step SP4 from the carrier concentration obtained in the step SP3 (Step SP5 in FIG. 3).

It should be noted that the unit of the carrier concentration and the concentration of donors is cm⁻³ and the concentration of the dopants is atoms/cm³. Since a single dopant atom releases a single carrier, the carrier concentration equals to the dopant concentration, if there are no thermal donors.
Therefore, the carrier concentration for n-type semiconductor is given by
carrier concentration = dopant concentration + concentration of thermal donors,
and that for p-type semiconductor is given by carrier concentration = dopant concentration - concentration of thermal donors.
Then the resistivity solely due to dopants is obtained by converting the obtained concentration of dopants to resistivity using Irvin's curve (Step SP6 in FIG.3).

As in the embodiment described above according to the present invention, the resistivity solely due to the dopant is available by correcting on the basis of the relational expression (1) obtained beforehand to eliminate the influence of the thermal donors that are regenerated during extraction from the furnace due to a thermal history of 450 °C, when wafers are subjected to the donor-killer process collectively in the vertical furnace.

Thus even for large diameter Si wafers, the resistivity solely due to the dopant is accurately evaluated after the wafers have been heat-treated in a vertical furnace which ensures high productivity, that is high working efficiency.

The measurement method according to the present invention is not restricted by the characteristics of wafers whose resistivity is to be measured. The present invention, however, is more effective because the influence of thermal donors to resistivity variation becomes more significant for high resistivity, which is 2 Ω-m or higher, for example.

The measurement method according to the present invention for resistivity of Si wafers will be further explained based on embodiments. In the embodiments the following experiments were performed.

### EXPERIMENT 1

In Experiment 1, among the steps the preparation process shown in FIG. 1, steps up to obtainment of a region of resistivity-stable grooves are performed.

Twenty (20) n-type Si wafers with a diameter of 200 mm, having oxygen concentration of 1.0x10¹⁸ atoms/cm³ (Old ASTM), were prepared and mounted on a vertical boat along the vertical direction at equal intervals. The boat was accommodated in a vertical furnace and a donor killer process was performed at a maximum temperature of 650 °C for 30 min in an N₂ atmosphere. After the treatment, wafers are extracted at a speed of 100 mm/min and the resistivity of the wafers were measured. In addition temperature change at positions of the vertical boat, the upper, central and the lower region, was observed during the process from the heat treatment to extraction. This experiment gave results that the experiencing time, or passing duration, at a temperature of 450 °C at which thermal donors are to be regenerated is the longest at the lower region of the boat and the shortest at the upper region, and that there exists a region where the experiencing time at 450 °C is constant in the central region.

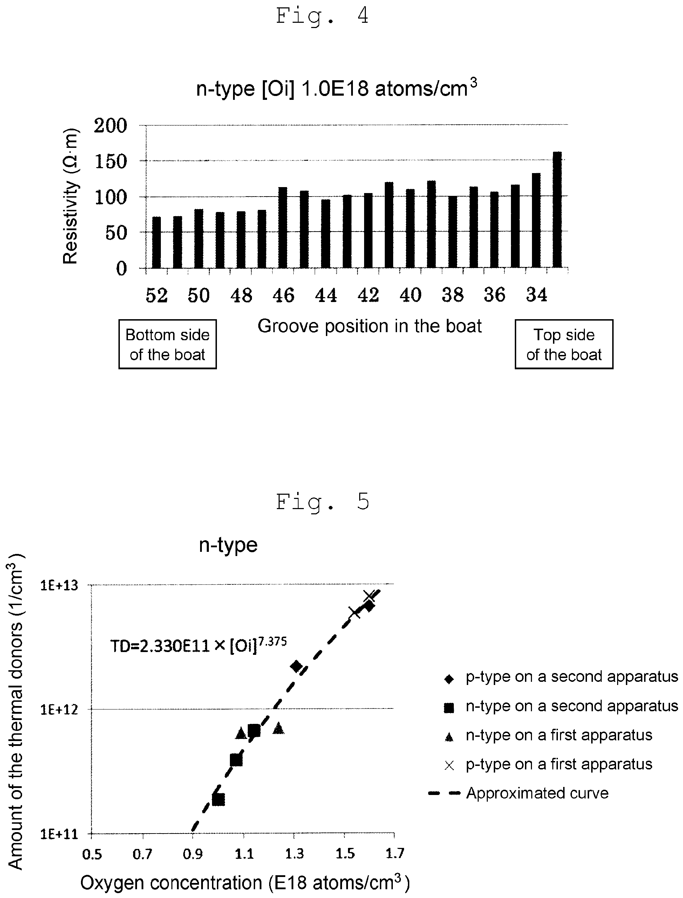

A graph of resistivity of wafers after heat treatment mounted from the upper to lower regions of the boat is shown in FIG.4, where the vertical axis is resistivity (Ω-m) and the horizontal axis is position of grooves on the boat. As FIG. 4 shows that the resistivity at the lower region of the boat is lower, and higher at the upper region of the boat, and substantially constant at the central region.
It is confirmed from the above results that the experiencing time at 450 °C may presumably have an influence to resistivity of wafers, and that the central region of the boat may be defined as a resistivity-stable region.

### EXPERIMENT 2

Among the steps of a preparation process shown in FIG. 1, steps of obtaining a relational expression that relates oxygen concentration to a concentration of thermal donors were performed in EXPERIMENT 2. A plurality of n-type Si wafers W having different oxygen concentration levels were mounted on grooves in the resistivity-stable region of the vertical boat. The vertical boat was accommodated in the vertical furnace. The donor killer process was performed at a maximum temperature of 650 °C for 30 min in an N₂ atmosphere. Oxygen concentration and resistivity of the first resistivity group of the wafers were measured; the oxygen concentration and the dopant concentration converted from the resistivity are shown in a column of the vertical furnace of a table in FIG. 7.

In addition, a plurality of Si wafers W were subjected to a heat treatment at a maximum temperature of 650 °C for 30 min in an N₂ atmosphere in a single-wafer type RTP furnace, and cooled down to 300 °C at a cooling speed of faster than 50 °C/s. Then, oxygen concentration and resistivity of the second resistivity group of the wafers were measured; the oxygen concentration and the dopant concentration converted from the resistivity are shown in a column of RTP of the table in FIG 7.

A relation between the oxygen concentration and the concentration of thermal donors for each oxygen concentration level was obtained from the difference of resistivity of the first and second resistivity group corresponding to the difference of the concentration of dopant, i.e., the estimated values in the table of FIG. 7. The results are plotted on a graph in FIG. 5, where the horizontal axis denotes the oxygen concentration (/cm³) and the vertical axis the concentration of thermal donors (10¹⁸ atoms/cm³). A relational expression (4) is obtained from the curve plotted in the graph,$TD = 2.33 \times {10}^{11} \times {\left[Oi\right]}^{7.375} ,$ where TD and Oi denote the concentration of thermal donors and the oxygen concentration, respectively.

### EXPERIMENT 3

In EXPERIMENT 3, p-type and n-type Si wafers were mixedly mounted on grooves in the resistivity-stable region of a first vertical boat in the vertical furnace, and were subjected to a heat treatment at 650 °C or higher for 30 min, and cooled down to 300 °C and extracted at an elevator moving speed, or extraction speed, of 100 mm/min. After extraction, the concentration of thermal donors against the oxygen concentration of each wafer are plotted on a graph shown in FIG. 5, where a cross × and a triangle △ denote values for p-type and n-type wafers, respectively.

Then, p-type and n-type Si wafers were mixedly mounted on grooves in the resistivity-stable region of a second vertical boat in the vertical furnace, and were subjected to a heat treatment at 650 °C or higher for 30 min, and cooled down to 300 °C and extracted at an elevator moving speed, or extraction speed, of 100 mm/min. After extraction, the concentration of thermal donors against the oxygen concentration of each wafer are plotted on a graph shown in FIG. 5, where a rhombus ◊ and a square □ denote values for p-type and n-type wafers, respectively. All the values of the results of the experiments above are plotted along a curve given by the expression (4). Therefore, it is confirmed that the expression (2) obtained in EPERIMENT 2 can be applicable to cases of heat treatment under the same condition, regardless of p-type or n-type Si wafers.

### List of reference numerals:

- 1: a vertical boat
- 2: a vertical-type heat treatment furnace
- W: Si wafer(s)

## Claims

1. A method for measuring resistivity of a Si product wafer having a predetermined resistivity and oxygen concentration, the method comprising:
mounting (S5) a plurality of wafers having different oxygen concentration levels in a boat (1) being a vertical type wafer boat in a region of the boat (1) where the measured resistivity is found to be constant;
inserting the boat (1) in a vertical heat treatment furnace (2);
performing (S6) a donor killer treatment on the wafers in the vertical heat treatment furnace (2) at a temperature of 650 °C for a duration of 30 minutes in a N₂ atmosphere;
extracting the boat (1) at a speed of at least 100 mm/min from the vertical heat treatment furnace (2);
measuring (S7) resistivity of the wafers as a first resistivity group of a plurality of Si wafers subjected to influences of regenerated thermal donors;
processing (S8) each of the wafers in a single-wafer type rapid thermal processing furnace at a temperature of 650 °C or higher for a duration of 30 minutes in a N₂ atmosphere;
cooling (S8) down each of the wafers to 300 °C at a rate of 50 °C/s or faster;
measuring (S8) resistivity of the wafers as a second resistivity group of a plurality of Si wafers being not affected by thermal donors;
obtaining (S9) a relational expression between the concentration of the regenerated thermal donors and each oxygen concentration level, based on difference between the resistivity of the wavers measured as the first resistivity group and the resistivity of the wavers measured as the second resistivity group for each oxygen concentration level;
accommodating (SP1) a product wafer in a vertical boat in a range of mounting area along a vertical direction of the vertical boat where wafers have the same resistivity after extraction from the vertical heat treatment furnace;
subjecting (SP1) the product wafer to a donor killer treatment for annihilation of thermal donors in a vertical heat treatment furnace (2) at a temperature of 650 °C or higher for a duration of 30 minutes in a N₂ atmosphere;
extracting (SP1) the vertical boat from the vertical heat treatment furnace at a speed of at least 100 mm/min;
measuring (SP2) the resistivity and the oxygen concentration of the product wafer;
obtaining (SP3) concentration of carriers including dopants and regenerated thermal donors based on the measured resistivity of the product wafer;
obtaining (SP4) the concentration of the regenerated thermal donors contained in the product wafer using the relational expression based on the measured oxygen concentration;
obtaining (SP5) the concentration of the dopants that is found by subtracting the concentration of the regenerated thermal donors from the measured carrier concentration; and
converting (SP6) the concentration of the dopants into resistivity solely due to dopants.

2. The method for measuring the resistivity according to Claim 1, wherein the region of the boat (1) where the measured resistivity is found to be constant is determined by:
loading (S1) a plurality of wafers on a boat (1) being a vertical type wafer boat;
performing (S2) a donor killing treatment on the wafers in a vertical heat treatment furnace (2) at a temperature of 650 °C for a duration of 30 minutes in a N₂ atmosphere;
extracting (S3) the boat (1) at a speed of at least 100 mm/min from the vertical heat treatment furnace (2);
measuring (S3) a resistivity of each waver after extraction from the vertical heat treatment furnace (2); and
determining (S4) the region in the boat (1) where the measured resistivity is found to be constant.

3. The method for measuring the resistivity according to Claim 1 or 2, wherein the relational expression is given by an expression (1) below, by letting TD denote the concentration of the regenerated thermal donors, Oi the oxygen concentration, A a coefficient, and B an exponent: $TD = A {\left[Oi\right]}^{B} .$

## Patentansprüche

1. Verfahren zum Messen des spezifischen Widerstands eines Si-Produkt-Wafers, der einen vorbestimmten spezifischen Widerstand und Sauerstoffkonzentration aufweist, wobei das Verfahren Folgendes umfasst:
Montieren (S5) einer Vielzahl von Wafern, die unterschiedliche Sauerstoffkonzentrationsniveaus aufweisen, in einem Träger (1), der ein Waferträger vom vertikalen Typ ist, in einem Bereich des Trägers (1), wobei sich der gemessene spezifische Widerstand als konstant erwiesen hat;
Einsetzen des Trägers (1) in einen vertikalen Wärmebehandlungsofen (2);
Durchführen (S6) einer Donatoren-Killer-Behandlung an den Wafern in dem vertikalen Wärmebehandlungsofen (2) bei einer Temperatur von 650 °C für eine Dauer von 30 Minuten in einer N₂-Atmosphäre;
Extrahieren des Trägers (1) bei einer Geschwindigkeit von mindestens 100 mm/min aus dem vertikalen Wärmebehandlungsofen (2);
Messen (S7) des spezifischen Widerstands der Wafer als eine erste spezifische Widerstandsgruppe einer Vielzahl von Si-Wafern, die dem Einfluss von regenerierten thermischen Donatoren ausgesetzt wurden;
Bearbeiten (S8) von jedem der Wafer in einem Ofen für schnelles thermisches Bearbeiten von Einzelwafern bei einer Temperatur von 650 °C oder höher für eine Dauer von 30 Minuten in einer N₂-Atmosphäre;
Herunterkühlen (S8) von jedem der Wafer auf 300 °C bei einer Rate von 50 °C/s oder schneller;
Messen (S8) des spezifischen Widerstands der Wafer als zweite spezifische Widerstandsgruppe einer Vielzahl von Si-Wafern, die nicht durch thermische Donatoren beeinflusst wurden;
Erhalten (S9) eines Relationsausdrucks zwischen der Konzentration der regenerierten thermischen Donatoren und jedem Sauerstoffkonzentrationsniveau, basierend auf einer Differenz zwischen dem spezifischen Widerstand der Wafers, der als die erste spezifische Widerstandsgruppe gemessen wurde, und dem spezifischen Widerstand der Wafers, der als die zweite spezifische Widerstandsgruppe für jedes Sauerstoffkonzentrationsniveau gemessen wurde;
Unterbringen (SP1) eines Produktwafers in einem vertikalen Träger in einem Bereich von Montagefläche entlang einer vertikalen Richtung des vertikalen Trägers, wobei die Wafer nach Extraktion aus dem vertikalen Wärmebehandlungsofen den gleichen spezifischen Widerstand aufweisen;
Unterziehen (SP1) des Produktwafers einer Donatoren-Killer-Behandlung zur Annihilation von thermischen Donatoren in einem vertikalen Wärmebehandlungsofen (2) bei einer Temperatur von 650 °C oder höher für eine Dauer von 30 Minuten in einer N₂-Atmosphäre;
Extrahieren (SP1) des vertikalen Trägers aus dem vertikalen Wärmebehandlungsofen bei einer Geschwindigkeit von mindestens 100 mm/min;
Messen (SP2) des spezifischen Widerstands und der Sauerstoffkonzentration des Produktwafers;
Erhalten (SP3) der Konzentration von Trägern, die Dotierstoffe und regenerierte thermische Donatoren einschließen, basierend auf dem gemessenen spezifischen Widerstand des Produktwafers;
Erhalten (SP4) der Konzentration der regenerierten thermischen Donatoren, die in dem Produktwafer enthalten sind, unter Verwendung des Relationsausdrucks basierend auf der gemessenen Sauerstoffkonzentration;
Erhalten (SP5) der Konzentration der Dotierstoffe, die durch Subtrahieren der Konzentration der regenerierten thermischen Donatoren von der gemessenen Trägerkonzentration ermittelt wird; und
Umwandeln (SP6) der Konzentration der Dotierstoffe in spezifischen Widerstand einzig aufgrund der Dotierstoffe.

2. Verfahren zum Messen des spezifischen Widerstands nach Anspruch 1, wobei der Bereich des Trägers (1), in dem sich der gemessene spezifische Widerstand als konstant erwiesen hat, bestimmt wird durch:
Laden (S1) einer Vielzahl von Wafern auf einen Träger (1), der ein Waferträger vom vertikalen Typ ist;
Durchführen (S2) einer Donatoren-Killer-Behandlung an den Wafern in dem vertikalen Wärmebehandlungsofen (2) bei einer Temperatur von 650 °C für eine Dauer von 30 Minuten in einer N₂-Atmosphäre;
Extrahieren (S3) des Trägers (1) bei einer Geschwindigkeit von mindestens 100 mm/min aus dem vertikalen Wärmebehandlungsofen (2);
Messen (S3) eines spezifischen Widerstands von jedem Wafer nach Extraktion aus dem vertikalen Wärmebehandlungsofen (2); und
Bestimmen (S4) des Bereichs in dem Träger (1), in dem sich der gemessene spezifische Widerstand als konstant erwiesen hat.

3. Verfahren zum Messen des spezifischen Widerstands nach Anspruch 1 oder 2, wobei der Relationsausdruck gegeben ist durch einen nachstehenden Ausdruck (1), indem zugelassen wird, dass TD die Konzentration der regenerierten thermischen Donatoren, Oi die Sauerstoffkonzentration, A einen Koeffizienten und B einen Exponenten bezeichnet: $TD = A {\left[Oi\right]}^{B} .$

## Revendications

1. Procédé de mesure de la résistivité d'une tranche de produit en Si présentant une résistivité et une concentration en oxygène prédéterminées, le procédé comprenant :
le montage (S5) d'une pluralité de tranches présentant différents niveaux de concentration en oxygène dans une nacelle (1) qui est une nacelle pour tranches de type vertical dans une région de la nacelle (1) où la résistivité mesurée se révèle être constante ;
l'insertion de la nacelle (1) dans un four vertical de traitement thermique (2) ;
la réalisation (S6) d'un traitement d'élimination des donneurs sur les tranches dans le four vertical de traitement thermique (2) à une température de 650 °C pendant une durée de 30 minutes dans une atmosphère de N₂ ;
l'extraction de la nacelle (1) à une vitesse d'au moins 100 mm/min hors du four vertical de traitement thermique (2) ;
la mesure (S7) de la résistivité des tranches en tant que premier groupe de résistivité d'une pluralité de tranches de Si soumises aux influences de donneurs thermiques régénérés ;
le traitement (S8) de chacune des tranches dans un four de traitement thermique rapide de type à une seule tranche à une température de 650 °C ou plus pendant une durée de 30 minutes dans une atmosphère de N₂ ;
le refroidissement (S8) de chacune des tranches jusqu'à 300 °C à une vitesse de 50 °C/s ou à une vitesse plus rapide ;
la mesure (S8) de la résistivité des tranches en tant que deuxième groupe de résistivité d'une pluralité de tranches de Si qui ne sont pas affectées par des donneurs thermiques ;
l'obtention (S9) d'une expression relationnelle entre la concentration des donneurs thermiques régénérés et chaque niveau de concentration en oxygène, sur la base de la différence entre la résistivité des tranches mesurée en tant que premier groupe de résistivité et la résistivité des tranches mesurée en tant que deuxième groupe de résistivité pour chaque niveau de concentration en oxygène ;
le placement (SP1) d'une tranche de produit dans une nacelle verticale dans une plage de zone de montage le long d'une direction verticale de la nacelle verticale où des tranches présentent la même résistivité après extraction hors du four vertical de traitement thermique ;
la soumission (SP1) de la tranche de produit à un traitement d'élimination des donneurs pour l'annihilation des donneurs thermiques dans un four vertical de traitement thermique (2) à une température de 650 °C ou
plus pendant une durée de 30 minutes dans une atmosphère de N₂ ;
l'extraction (SP1) de la nacelle verticale hors du four vertical de traitement thermique à une vitesse d'au moins 100 mm/min ;
la mesure (SP2) de la résistivité et de la concentration en oxygène de la tranche de produit ;
l'obtention (SP3) d'une concentration de porteurs incluant des dopants et des donneurs thermiques régénérés sur la base de la résistivité mesurée de la tranche de produit ;
l'obtention (SP4) de la concentration des donneurs thermiques régénérés contenus dans la tranche de produit en utilisant l'expression relationnelle sur la base de la concentration en oxygène mesurée ;
l'obtention (SP5) de la concentration des dopants qui est trouvée en soustrayant la concentration des donneurs thermiques régénérés de la concentration de porteurs mesurée ; et
la conversion (SP6) de la concentration des dopants en résistivité due uniquement aux dopants.

2. Procédé de mesure de la résistivité selon la revendication 1, dans lequel la région de la nacelle (1) où la résistivité mesurée se révèle être constante est déterminée par :
le chargement (S1) d'une pluralité de tranches sur une nacelle (1) qui est une nacelle pour tranches de type vertical ;
la réalisation (S2) d'un traitement d'élimination des donneurs sur les tranches dans un four vertical de traitement thermique (2) à une température de 650 °C pendant une durée de 30 minutes dans une atmosphère de N₂ ;
l'extraction (S3) de la nacelle (1) à une vitesse d'au moins 100 mm/min hors du four vertical de traitement thermique (2) ;
la mesure (S3) d'une résistivité de chaque tranche après extraction hors du four vertical de traitement thermique (2) ; et
la détermination (S4) de la région dans la nacelle (1) où la résistivité mesurée se révèle être constante.

3. Procédé de mesure de la résistivité selon la revendication 1 ou la revendication 2, dans lequel l'expression relationnelle est donnée par une expression (1) ci-dessous, où TD désigne la concentration des donneurs thermiques régénérés, Oi la concentration en oxygène, A un coefficient et B un exposant : $TD = A {\left[Oi\right]}^{B} .$
